# EUROPÄISCHE PATENTANMELDUNG

(11) **EP 1 845 763 A2**
(43) Veröffentlichungstag der Anmeldung: **17.10.2007**
(21) Anmeldenummer: 07104890.4
(22) Anmeldetag: 26.03.2007
(51) Int. Cl.: H05K 5/04

(54) **Gehäuse für die Aufnahme von Leiterkarten und/oder weiteren elektronischen und/oder elektrischen Komponenten**

(30) Priorität: 12.04.2006 DE 202006006133 U
(71) Anmelder: DResearch Digital Media Systems GmbH, 10319 Berlin (DE)
(72) Erfinder: Weber, Dr. Michael, 12683, Berlin (DE)
(74) Vertreter: Schneider, Henry

(57) **Zusammenfassung**

Die Erfindung betrifft ein Gehäuse für die Aufnahme von Leiterkarten, elektronischen und/oder elektrischen Komponenten oder dergleichen.

Es ist vorgesehen, dass das Gehäuse (1) im Wesentlichen aus zwei gleichartig ausgebildeten Profilen (2, 3) besteht, von denen das eine Profil (2) den Boden (5) und eine erste Seitenwand (11) des Gehäuses (1) und das zweite Profil (3) die Decke (7) und die zweite Seitenwand (13) des Gehäuses (1) bildet, wobei die gleichartig ausgebildeten Profile (2, 3) an den freien Enden ihrer Schenkel (6, 8, 12, 14) Verbindungselemente (4) besitzen, über die die beiden gleichartig ausgebildeten Profile (2, 3) bei einer um 180° versetzt zueinander vorgesehenen Anordnung ineinander verschiebbar oder aufeinander steckbar sind und in der dabei eingenommenen Endposition gegebenenfalls miteinander verbindbar sind.

## Beschreibung

Die Erfindung betrifft ein Gehäuse für die Aufnahme von Leiterkarten und/oder weiteren elektronischen und/oder elektrischen Komponenten mit den im Oberbegriff des Anspruches 1 genannten Merkmalen.

Es ist bekannt, Gehäuse für die Aufnahme von Leiterkarten und/oder weiteren elektronischen und elektrischen Komponenten sowohl aus Kunststoff als auch aus Metall herzustellen. Dabei sind die vielfältigsten Ausbildungen derartiger Gehäuse bekannt. Ein Grundprinzip dieser Gehäuse ist, dass sie aus mehreren Einzelteilen bestehen, die zur Bildung des Gehäuses beispielsweise durch Schraub- oder Schweißverbindungen zusammengehalten werden. Wird eine Reduzierung der Einzelteile des Gehäuses vorgenommen, so kommen zur Bildung des Gehäuses, wie aus der DE 102 19 972 A1 hervorgeht, verschraubte Schalengehäuse aus Blechbiegeteilen, sowie mehrteilige Gussgehäuse, aber auch mehrteilige Steckgehäuse aus Kunststoff zur Anwendung.

Nachteilig bei diesen Gehäusen ist, dass sie bei Metallausführung meistens als Blechbiegeteil-Schraubkonstruktion ausgeführt sind, so dass die Montage sehr aufwendig und daher relativ kostenintensiv ist. Ein weiterer Nachteil ist aber auch, dass unabhängig vom zur Anwendung kommenden Material die Schraubenverbindungen an den Seiten sowie am Boden oder am Deckel sichtbar sind und daher oft störend wirken.

Unter Berücksichtigung der Vielzahl weiterer bekannter Gehäuse wird beispielsweise bei einem Gehäuse zur Aufnahme elektrischer und elektronischer Einbauten gemäß der DE 100 07 490 A1 von zwei zueinander parallel angeordneten, plattenförmigen Abdeckungen ausgegangen. Diese sind mittels vertikal zu den Abdeckungsebenen verlaufenden Profilschenkeln miteinander verbunden, wobei die beiden, der Gehäuse-Frontseite zugewandten Profilschenkel eine Innenfläche aufweisen, die vertikal zur Gehäusevorderseite angeordnet ist. Die Herstellung dieses Gehäuses ist jedoch ausgehend von der Vielzahl der zur Komplettierung des Gehäuses erforderlichen Einzelteile, insbesondere aber auch unter Berücksichtigung der benötigten Zeit zu seiner Montage, unverhältnismäßig aufwendig und somit ebenfalls mit relativ hohen Herstellungskosten verbunden.

Diese Nachteile werden auch durch ein ebenfalls bekanntes Gehäuse nach der DE 101 00 989 A1 nicht vermieden, bei dem auf eine Trägerplatte von Gehäusewänden elektromechanische und elektronische Komponenten montiert werden und bei dem neben den Gehäusewänden ausgehend von Metall als Material auch ein Deckel sowie Vorder- und Rückwände vorgesehen sind. Dabei ist an den Übergängen von der Trägerplatte zu den Seiten und von der Rückseite zum Deckel das Metallblech biegefähig, so dass die Gehäusewände später zusammengeklappt werden können. Um das Zusammenklappen zu ermöglichen, sind bei diesem Gehäuse Kunststoffscharniere vorgesehen. Während auf den Gehäusewänden aus Kunststoff bestehende Verschlusselemente aufgespritzt sind, die nach dem Zusammenklappen miteinander in Wirkverbindung stehen, werden in aufgeklappter Position der Gehäusewände die Seitenwände eingesteckt, wobei eine Befestigung durch Schnappverschlüsse erfolgt. Aus der Vielzahl der Bauteilkomponenten, die dieses Gehäuse erfordert, resultiert der hohe Aufwand zu seiner Herstellung und somit ebenfalls ein kostenungünstiges Gehäuse.

Der Herstellungsaufwand ist aber auch bei derartigen Gehäusen verhältnismäßig hoch, die, wie weiterhin durch die DE 195 01 340 C1 bekannt, aus einem u-förmigen Blech bestehen, bei dem zwei Stirnkanten zu einer Kastenform hochgebogen sind, oder bei dem Endstücke an das U-Mantelblech angeschweißt, angenietet oder mit diesem verschraubt sind und der Deckel aufgeschraubt ist. Das trifft auch für derartige Gehäuse zu, bei denen ausgehend von einem Blechgehäuse der Deckel über ein Scharnier schwenkbar an dem kastenförmigen Boden angelenkt ist. Daraus ergibt sich, dass bei allen diesen Bauarten stets viele unterschiedliche Einzelteile in verschiedenen Arbeitsschritten zusammengesetzt werden müssen.

Bei weiterhin bekannten Gehäusen zur Aufnahme elektrischer sowie elektronischer Komponenten, so nach der DE 101 13 688 A1, ist der Innenraum eines Baugruppenträgers durch ein abnehmbares Deckelteil verschließbar, indem dieses aufgesetzt und anschließend durch horizontales Verschieben in eine geschlossene Position gebracht wird. Dabei werden die Seitenwände des Deckelteiles durch einen Schubverschluss am Baugruppenträger gehalten, während das Deckelteil in seiner Gesamtheit durch Schrauben fixiert wird. Bei dieser Ausbildung der Gehäuse ist das Aufsetzen des Deckelteiles jedoch umständlich, da die Schubverschlüsse im Bereich der Seitenwände des Deckelteiles eingefädelt werden müssen. Das Einfädeln der Schubverschlussverbindung kann zwar vereinfacht werden, indem mit einem größeren Spiel gearbeitet wird, das aber führt wieder zu einer hinsichtlich der Dichtigkeit unzulänglichen Anbindung der Seitenwände des Deckelteiles an den Baugruppenträger.

Es hat sich somit gezeigt, dass unabhängig von der jeweiligen Ausbildung der Vielzahl bekannter Gehäuse zur Aufnahme von elektronischen und elektrischen Komponenten und zwar sowohl bei aus Metall als auch bei aus Kunststoff bestehenden Gehäusen ihre Ausbildung nicht immer optimal ist. Das nicht nur deshalb, weil sie ausgehend von der Vielzahl der zu ihrer Komplettierung benötigten Einzelteile mit einem relativ hohen Montageaufwand verbunden sind und daher kostenintensiv sind, sondern neben ihrem oftmals optisch störenden Eindruck nicht immer die Voraussetzungen dafür schaffen, dass beispielsweise ein Verschrauben von Leiterkarten auf der Montagefläche des Gehäuses sowie eine elektrische Verbindung zwischen den elektronischen und elektrischen Komponenten unaufwendig durchgeführt werden kann, da oftmals ein ungehinderter Zugang zur Innenfläche nicht zur Verfügung steht. Es wird bei den bekannten Gehäusen aber auch nicht immer berücksichtigt, dass es erforderlich ist, Einfluss auf eine Erhöhung der Wärmeabführung durch Verbesserung der Kühlung zu nehmen.

Der Erfindung liegt die Aufgabe zugrunde, ein Gehäuse für die Aufnahme von Leiterkarten und/oder weiteren elektronischen und/oder elektrischen Komponenten entsprechend dem Oberbegriff von Anspruch 1 zu schaffen, durch das bei Verringerung des Aufwandes zu seiner Herstellung und somit mit verringerten Kosten gleichzeitig u. a. bei einem ansprechenden Design die Voraussetzungen dafür geschaffen werden, dass zum Verschrauben von Leiterkarten auf der Montagefläche des Gehäuses sowie zur elektrischen Verbindung zwischen den elektronischen und/oder elektrischen Komponenten aber auch zu den Außenanschlüssen ein ungestörter Zugang zur relevanten Innenfläche des Gehäuses zur Verfügung steht, wobei auch auf eine Verbesserung der Wärmeabführung und auf ein wirksames, abdichtendes Verschließen des Gehäuses Einfluss zu nehmen ist.

Diese Aufgabe wird erfindungsgemäß durch ein Gehäuse mit den im Anspruch 1 genannten Merkmalen gelöst. Dadurch, dass das Gehäuse im Wesentlichen aus zwei gleichartig ausgebildeten Profilen besteht, von denen das eine Profil den Boden und eine erste Seitenwand des Gehäuses und das zweite Profil die Decke und die zweite Seitenwand des Gehäuses bildet, wobei die gleichartig ausgebildeten Profile an den freien Enden ihrer Schenkel Verbindungselemente besitzen, über die beide gleichartig ausgebildeten Profile bei einer um 180° versetzt zueinander vorgesehenen Anordnung ineinander verschiebbar oder aufeinander steckbar sind und in der dabei eingenommenen Endposition gegebenenfalls miteinander verschraubt sind, wird erreicht, dass bei Verringerung des Aufwandes zur Herstellung des Gehäuses und somit kontengünstig gleichzeitig bei einem ansprechenden Design u. a. auch die Voraussetzungen dafür vorliegen, dass zum Verschrauben von Leiterkarten auf der Montagefläche des Gehäuses sowie zur elektrischen Verbindung zwischen den elektronischen und/oder elektrischen Komponenten aber auch zu den Außenanschlüssen ein ungestörter Zugang zur relevanten Innenfläche des Gehäuses zur Verfügung steht, wobei auch auf eine Verbesserung der Kühlung und auf ein wirksames Verschließen des Gehäuses Einfluss genommen wird.

Gemäß einer ersten möglichen Ausbildung bestehen die Verbindungselemente aus an den freien Enden des Schenkel vorgesehenen Ausnehmungen sowie aus Anformungen, die derart an den freien Enden der Schenkel der Profile angeordnet sind, dass diese nach ihrer um 180° versetzt zueinander vorgenommenen Anordnung nach Abschluss der ineinander erfolgten Verschiebung der Profile miteinander korrespondieren. Aus dieser Verbindung der beiden gleichartig ausgebildeten Profile resultiert eine formschlüssige Verbindung, so dass durch diese gemeinsam mit einer geeigneten Wahl der Materialstärke eine große Robustheit des Gehäuses erreicht wird.

Alternativ können die Verbindungselemente aber auch aus an der freien Enden der Schenkel vorgesehenen Überlappungsflächen bestehen, die derart an den freien Enden der Schenkel der Profile angeordnet sind, dass sie gemeinsam nach der um 180° versetzt zueinander vorgenommenen Anordnung der Profile nach Abschluss der Fügung der Profile der Wandstärke des Gehäuses entsprechen und in dieser Position aufeinander geschraubt sind.

Um ausgehend von den beiden gleichartig ausgebildeten Profilen ein Gehäuse bereitzustellen, dass ein Kastenprofil mit rechteckigem Querschnitt bildet, sind nach einem weiteren Merkmal der Erfindung die beiden gleichartig ausgebildeten Profile des Gehäuses L-förmig ausgebildet, so dass sich bei der um 180° versetzt zueinander vorgesehener Anordnung der Profile nach ihrer ineinander erfolgten Verschiebung beziehungsweise nach ihrem aufeinander erfolgten Stecken das Kastenprofil ergibt.

Bei der Ausbildung des Gehäuses unter Verwendung der beiden gleichartig ausgebildeten Profile besitzt vorzugsweise die Seitenwand des Profils, das den Boden und die erste Seitenwand bildet, Durchbrüche und/oder Bohrungen, insbesondere für die Positionierung von Außenanschlüssen. Es versteht sich, dass bei einer größeren Systemgröße eine größere Fläche für die Positionierung von Außenanschlüssen durch Vergrößerung der Abmessungen der beiden gleichartig ausgebildeten Profile bei diesem Gehäuse zur Verfügung gestellt werden kann. Dabei können die Durchbrüche beziehungsweise die Bohrungen durch Fräsen, Bohren, Lasern etc. in die Seitenwand des Profils eingebracht werden.

Besonders bei einem Gehäuse, das aus zwei L-förmig ausgebildeten, gleichartigen Profilen gebildet ist, schafft die Erfindung die Voraussetzungen dafür, dass während der Montage weitgehend ein ungestörter Zugang zur relevanten Innenfläche, insbesondere zum Einführen von Außenanschlüssen in die durch die Durchbrüche und/oder Bohrungen geschaffenen Öffnungen der Seitenwand des Profils, das den Boden und die erste Seitenwand bildet, zur Verfügung steht. Dieser Zugang steht aber auch zum Verschrauben von Leiterkarten auf der Montagefläche zur Verfügung. Dabei können in Abhängigkeit von der Größe der aus den Leiterkarten und aus weiteren elektronischen und/oder elektrischen Komponenten bestehenden Systeme bei kleineren Systemen diese auf dem Boden des einen Profils und bei größeren Systemen sowohl auf dem Boden des einen Profils als auch an der Innenfläche des zweiten Profils der beiden gleichartig ausgebildeten Profile positioniert werden.

Erfolgt eine Positionierung von Leiterkarten und weiteren elektronischen und/oder elektrischen Komponenten sowohl auf dem Boden des einen Profils als auch beispielsweise an der Innenfläche des zweiten Profils, so wird die elektrische Verbindung vorteilhafterweise durch Kabelverbindungen realisiert. Das schließt jedoch nicht aus, dass bei einer derartigen Positionierung von Leiterkarten und weiteren elektronischen und/oder elektrischen Komponenten die elektrische Verbindung auch durch Steckverbindungen realisiert werden kann, wobei das Stecken nach dem Ineinanderschieben beziehungsweise nach dem Aufeinanderschrauben der beiden gleichartig ausgebildeten Profile des Gehäuses vornehmbar ist.

Damit durch das erfindungsgemäß ausgebildete Gehäuse gleichzeitig auch Einfluss auf eine verbesserte Wärmeabführung genommen wird, besitzen die beiden gleichartig ausgebildeten Profile, insbesondere der Schenkel des einen Profils, der die Decke bildet und der Schenkel des zweiten Profils, der den Boden bildet, auf ihrer nach außen zugerichteten Seite zumindest teilweise eine gerippte Kühlfläche. Diese trägt gleichzeitig auch dazu bei, um die Biegefestigkeit des Gehäuses zu erhöhen.

Damit aber auch ein Eindringen von Feuchtigkeit in den Innenraum des Gehäuses vermieden wird, ist nach dem Fügen der beiden gleichartig ausgebildeten Profile des Gehäuses sowohl der zwischen den Ausnehmungen und Anformungen als auch der zwischen den Überlappungsflächen gebildete Spalt vorzugsweise durch ein Dichtungsmaterial verschlossen.

Hinsichtlich einer elektromagnetischen Abschirmung schafft das Gehäuse nach der Erfindung ebenfalls günstige Voraussetzungen. So wird die elektromagnetische Abschirmung erreicht, indem die gleichartig ausgebildeten Profile des Gehäuses beim Aufeinanderstecken ihrer Überlappungsflächen über die Verschraubung elektrisch miteinander verbunden sind. Wird das Gehäuse durch das Ineinanderschieben der miteinander korrespondierenden Anformungen und Ausnehmungen der beiden gleichartig ausgebildeten Profile gebildet, so erfolgt die elektromagnetische Abschirmung vorzugsweise durch aufgeschraubte Abdeckungen an den nicht eloxierten Stirnseiten der gleichartig ausgebildeten Profile, durch die die gleichartig ausgebildeten Profile elektrisch miteinander verbunden sind.

In weiterer Ausgestaltung der Erfindung besitzen vorzugsweise beide gleichartig ausgebildeten Profile im Bereich der Decke sowie im Bereich des Bodens auf ihrer nach außen zugerichteten Seite Montagehilfen, über die das Gehäuse mit weiteren Gehäusen oder mit Komponenten eines Produktes am Einsatzort des Gehäuses mit seinen Leiterkarten und weiteren elektronischen und/oder elektrischen Komponenten verbindbar ist. Gemäß einer zweckmäßigen Ausbildung bestehen die Montagehilfen aus einer Nut, über die das Gehäuse auf einen Steg des weiteren Gehäuses oder der jeweiligen Komponente des Produktes am Einsatzort aufschiebbar ist.

Schließlich sind bei dem aus den beiden gleichartig ausgebildeten Profilen gebildeten Gehäuse die Funktionselemente, wie beispielsweise das Display und die Bedienelemente, aber auch weitere Außenanschlüsse zumindest in einer der seitlichen Abdeckungen des Gehäuses positionierbar.

Somit wird durch die Erfindung ein Gehäuse bereitgestellt, das ausgehend von einem im Stranggussverfahren hergestellten Profil beispielsweise gegenüber einem aus gebogenem Blech hergestellten Gehäuse auch noch hochwertiger und robuster wirkt, wobei die gerippte Kühlfläche diesen Eindruck noch verstärkt. Darüber hinaus bildet das erfindungsgemäße Gehäuse bei Vorgabe entsprechender Guidelines für die mechanische Gesamtkonstruktion sowie für den Leiterkartenentwurf genügend Freiheitsgrade, um eine größere Anzahl von Produkten auf Basis der beiden gleichartig ausgebildeten Profile zu realisieren. Daraus resultiert, dass gleichzeitig auch standardisierte Teillösungen zur Wiederverwendung realisierbar sind und ausgehend vom prinzipiellen Aufbau des Gehäuses ein einheitliches Aussehen geschaffen wurde.

Weitere bevorzugte Ausgestaltungen der Erfindung ergeben sich aus den übrigen, in den Unteransprüchen genannten Merkmalen.

Die Erfindung wird nachfolgend an einem Ausführungsbeispiel anhand der zugehörigen Zeichnungen näher erläutert. Es zeigen:
- Figur 1: einen Schnitt von zwei gleichartig ausgebildeten Profilen zur Bildung eines Gehäuses für die Aufnahme von Leiterkarten und/oder weiteren elektronischen und/oder elektrischen Komponenten;
- Figur 2: eine perspektivische Ansicht eines der gleichartig ausgebildeten Profile nach Figur 1;
- Figur 3: eine perspektivische Ansicht eines der gleichartig ausgebildeten Profile nach Figur 1 in gegenüber Figur 2 veränderter Ausbildung hinsichtlich seiner Abmessungen und mit in diesem positionierten Leiterkarten sowie elektronischen und elektrischen Komponenten und
- Figur 4: eine perspektivische Ansicht eines Gehäuses in vervollständigter Darstellung.

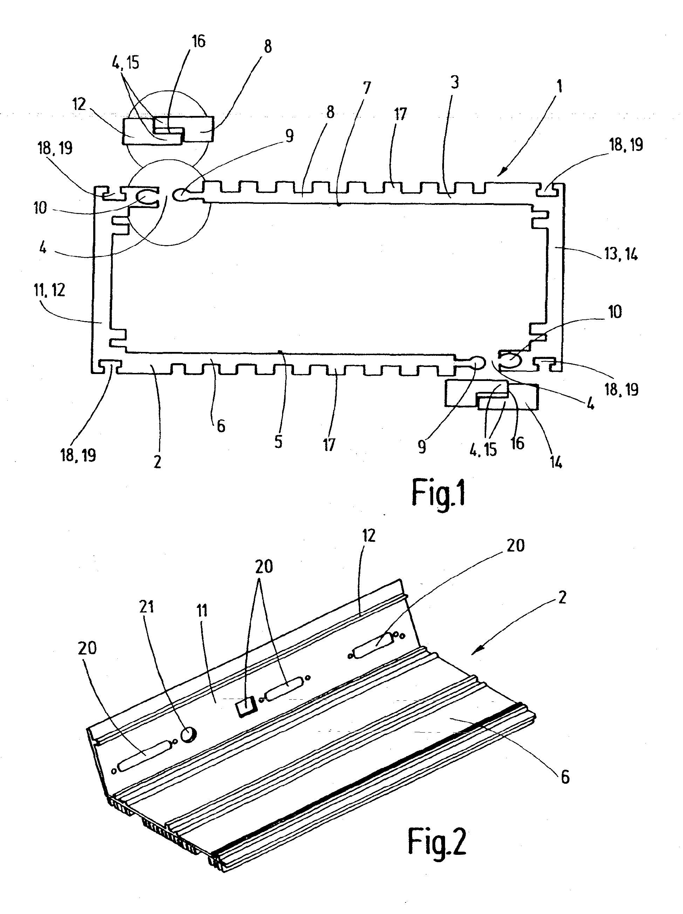

Gemäß Figur 1 kommen zur Ausbildung eines Gehäuses 1 zur Aufnahme von Leiterkarten und/oder weiteren elektronischen und elektrischen Komponenten zwei gleichartig ausgebildete Profile 2, 3 zur Anwendung, die zur Bildung eines Kastenprofils mit rechteckigem Querschnitt L-förmig ausgebildet sind. Um dieses zu erreichen, sind die beiden gleichartig ausgebildeten Profile 2, 3 um 180° versetzt zueinander angeordnet. Damit ausgehend von dieser Anordnung eine formschlüssige Verbindung der beiden gleichartig ausgebildeten Profile 2, 3 durch Verbindungselemente 4 vorgenommen werden kann, besitzt sowohl der den Boden 5 des Gehäuses bildende Schenkel 6 des Profils 2 als auch der die Decke 7 des Gehäuses 1 bildende Schenkel 8 des Profils 3 Anformungen 9, die mit Ausnehmungen 10 korrespondieren, die sowohl in dem die erste Seitenwand 11 des Gehäuses 1 bildenden Schenkel 12 des Profils 2 als auch in dem die zweite Seitenwand 13 des Gehäuses 1 bildenden Schenkel 14 des Profils 3 vorgesehen sind. Unter Berücksichtigung dieser Verbindungselemente 4 in Form der miteinander korrespondierenden Anformungen 9 und Ausnehmungen 10 erfolgt eine formschlüssige Verbindung der beiden gleichartig ausgebildeten Profile 2, 3, indem diese ineinander geschoben werden.

Aus Figur 1 ist weiterhin ersichtlich, dass alternativ die formschlüssige Verbindung der beiden gleichartig ausgebildeten Profile 2, 3 zur Bildung des Gehäuses 1 auch durch Verbindungselemente 4 erreicht werden kann, die aus an den freien Enden der Schenkel 6, 8, 12, 14 vorgesehenen Überlappungsflächen 15 bestehen. Ist unter Anwendung dieser Überlappungsflächen 15 eine Fügung der beiden gleichartig ausgebildeten Profile 2, 3 vollzogen, so wird, nachdem die gleichartig ausgebildeten Profile 2, 3 an den Überlappungsflächen 15 aufeinander geschraubt sind, der zwischen den Überlappungsflächen 15 sich ergebende Spalt 16 durch ein Dichtungsmaterial verschlossen, um ein Eindringen von Feuchtigkeit in das Gehäuse zu vermeiden.

Dieses Dichtungsmaterial kommt auch dann zur Anwendung, wenn Verbindungselemente 4 in Form der miteinander korrespondierenden Anformungen 9 und Ausnehmungen 10 zur Bildung des Gehäuses eingesetzt werden.

Aus der Figur 1 ist aber auch ersichtlich, dass die nach außen zugerichtete Seite sowohl des Schenkels 8 des Profils 3, der die Decke 7 des Gehäuses 1 bildet, als auch der Schenkel 6 des Profils 2, der den Boden 5 des Gehäuses 1 bildet, als gerippte Kühlfläche 17 ausgebildet ist. Dieser kommt zwar überwiegend die Aufgabe einer verbesserten Wärmeabführung zu, aber durch diese wird gleichzeitig auch eine erhöhte Biegefestigkeit des Gehäuses 1 erreicht. Außerdem besitzt sowohl das Profil 2 im Bereich des Bodens 5 als auch das Profil 3 im Bereich der Decke 7 auf der nach außen zugerichteten Seite Montagehilfen 18 in Form einer Nut 19, über die das Gehäuse 1 beispielsweise mit weiteren Gehäusen verbindbar ist, wobei dann das Gehäuse 1 über die Nut 19 mit einem nicht weiter dargestellten Steg durch Aufschieben in Wirkverbindung steht.

Die perspektivische Ansicht nach Figur 2 zeigt, dass in die Seitenwand 11 des Schenkels 12 des Profils 2 Durchbrüche 20 und zumindest eine Bohrung 21, insbesondere für Außenanschlüsse, vorgesehen sind. Dabei steht hierfür ein großer Bereich zur Verfügung. Daraus resultiert, dass das Profil 2 und somit auch das Profil 3 gemäß Figur 1 für ein Gehäuse 1 ausgelegt ist, das einem relativ großen System zugeordnet ist.

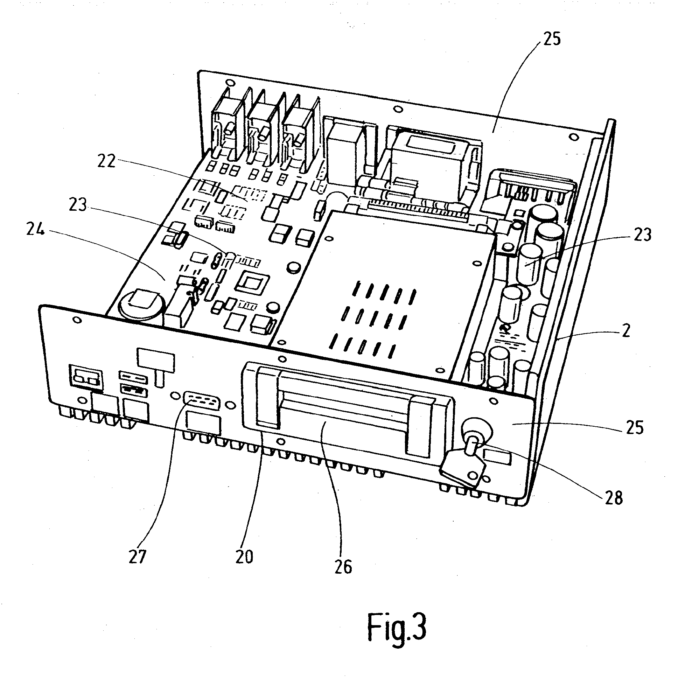

Figur 3 zeigt das L-förmig ausgebildete Profil 2 bevor es mit dem ebenfalls L-förmig ausgebildeten Profil 3 gemäß Figur 1 kraftschlüssig verbunden wird und lässt erkennen, dass für die Positionierung von Leiterkarten 22 sowie elektronischer und elektrischer Komponenten 23 auf der Montagefläche 24 ein ungehinderter Zugang zur Verfügung steht. Aus dieser Figur ist aber auch ersichtlich, dass das Profil 2 vor der Vornahme der Positionierung der Komponenten auf der Montagefläche 24 durch die seitlichen Abdeckungen 25 vervollständigt wurde, die ebenfalls Durchbrüche 20, beispielsweise für ein Display 26 aber auch für Außenanschlüsse 27 und Bedienelemente 28 besitzen. Sind die Leiterkarten 22 sowie die elektronischen und elektrischen Komponenten 23 auf der Montagefläche 24 sowie an den seitlichen Abdeckungen 25 positioniert, so erfolgt die elektrische Verbindung durch Kabelbündel.

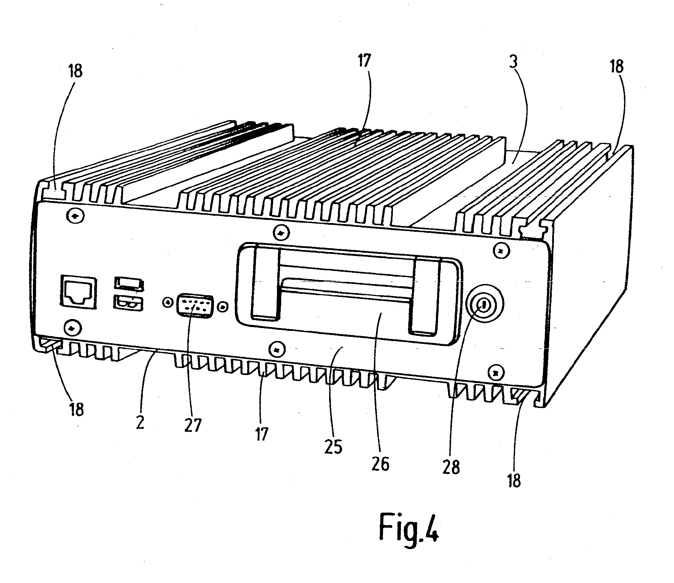

Ist die Positionierung der Leiterkarten 22 sowie der elektronischen und elektrischen Komponenten 23 auf der Montagefläche 24 sowie an den seitlichen Abdeckungen 25 abgeschlossen und schließlich die elektrische Verbindung durch Kabel hergestellt, so wird das L-förmig ausgebildete Profil 3 mit dem L-förmig ausgebildeten Profil 2 über die Verbindungselemente 4 (Figur 1) kraftschlüssig verbunden, so dass auf der Grundlage des Gehäuses 1 nach Figur 1 mit seiner gerippten Kühlfläche 17 sowie mit seinen Montagehilfen 24 nach seiner Vervollständigung ein Gerät gemäß Figur 4 zur Verfügung steht.

## Patentansprüche

1. Gehäuse für die Aufnahme von Leiterkarten, elektronischen und/oder elektrischen Komponenten oder dergleichen, **dadurch gekennzeichnet, dass** das Gehäuse (1) im Wesentlichen aus zwei gleichartig ausgebildeten Profilen (2, 3) besteht, von denen das eine Profil (2) den Boden (5) und eine erste Seitenwand (11) des Gehäuses (1) und das zweite Profil (3) die Decke (7) und die zweite Seitenwand (13) des Gehäuses (1) bildet, wobei die gleichartig ausgebildeten Profile (2, 3) an den freien Enden ihrer Schenkel (6, 8, 12, 14) Verbindungselemente (4) besitzen, über die die beiden gleichartig ausgebildeten Profile (2, 3) bei einer um 180° versetzt zueinander vorgesehenen Anordnung ineinander verschiebbar oder aufeinander steckbar sind und in der dabei eingenommenen Endposition gegebenenfalls miteinander verbindbar sind.

2. Gehäuse nach Anspruch 1, **dadurch gekennzeichnet, dass** Durchbrüche und/oder Bohrungen für die Aufnahme von Funktionselementen, wie beispielsweise für ein Display und Bedienelemente aber auch für Außenanschlüsse vorgesehen sind.

3. Gehäuse nach Anspruch 1, **dadurch gekennzeichnet, dass** die Verbindungselemente (4) aus an den freien Enden der Schenkel (6, 8, 12, 14) vorgesehenen Ausnehmungen (10) sowie aus Anformungen (9) bestehen, die derart an den freien Enden der Schenkel (6, 8, 12, 14) der Profile (2, 3) angeordnet sind, dass diese nach ihrer um 180° versetzt zueinander vorgenommenen Anordnung nach Abschluss der ineinander erfolgten Schiebung der Profile (2, 3) miteinander korrespondieren.

4. Gehäuse nach Anspruch 1, **dadurch gekennzeichnet, dass** die Verbindungselemente (4) aus an den freien Enden der Schenkel (6, 8, 12, 14) vorgesehenen Überlappungsflächen (15) bestehen, die derart an den freien Enden der Schenkel (6, 8, 12, 14) der Profile (2, 3) angeordnet und ausgebildet sind, dass sie gemeinsam nach der um 180° versetzt zueinander vorgenommenen Anordnung der Profile (2, 3) nach Abschluss der Fügung der Profile (2, 3) der Wandstärke des Gehäuses (1) entsprechen und in dieser Endposition aufeinander geschraubt sind.

5. Gehäuse nach einem der vorhergehenden Ansprüche, **dadurch gekennzeichnet, dass** die beiden gleichartig ausgebildeten Profile (2, 3) des Gehäuses (1) L-förmig ausgebildet sind, derart, dass bei der um 180° versetzt zueinander vorgesehenen Anordnung der Profile (2, 3) nach ihrer ineinander erfolgten Verschiebung beziehungsweise nach ihrem aufeinander erfolgten Stecken ein Kastenprofil mit rechteckförmigem Querschnitt gebildet ist.

6. Gehäuse nach Anspruch 5, **dadurch gekennzeichnet, dass** vorzugsweise die Seitenwand des Profils (2), das den Boden (5) und die erste Seitenwand (11) bildet, Durchbrüche (20) und/oder Bohrungen (21), insbesondere für die Positionierung von Außenanschlüssen (27), besitzt.

7. Gehäuse nach Anspruch 6, **dadurch gekennzeichnet, dass** die Durchbrüche (20) beziehungsweise die Bohrungen (21) durch Fräsen, Bohren, Lasern etc. in die erste Seitenwand (11) des Profils (2) eingebracht sind.

8. Gehäuse nach Anspruch 7, **dadurch gekennzeichnet, dass** in Abhängigkeit von der Größe der aus den Leiterkarten (22), elektronischen und/oder elektrischen Komponenten (23) bestehenden Systeme bei kleineren Systemen diese auf dem Boden (5) des einen Profils (2) und bei größeren Systemen sowohl auf dem Boden (5) des Profils (2) als auch an der Innenfläche des zweiten Profils (3) der beiden gleichartig ausgebildeten Profile (2, 3) positioniert sind.

9. Gehäuse nach Anspruch 8, **dadurch gekennzeichnet, dass** bei der Positionierung von Leiterkarten (22) und/oder weiteren elektronischen und/oder elektrischen Komponenten (23) sowohl auf dem Boden (5) des einen Profils (2) als auch beispielsweise an den Innenflächen des zweiten Profils (3) die elektrische Verbindung durch Kabelbündel realisiert ist.

10. Gehäuse nach Anspruch 8, **dadurch gekennzeichnet, dass** bei der Positionierung von Leiterkarten (22) und/oder weiteren elektronischen und/oder elektrischen Komponenten (23) sowohl auf dem Boden (5) des einen Profils (2) als auch beispielsweise an der Innenfläche des zweiten Profils (3) die elektrische Verbindung durch Steckverbindungen realisiert ist, wobei das Stecken nach dem Ineinanderschieben beziehungsweise nach dem Aufeinanderschrauben der beiden gleichartig ausgebildeten Profile (2, 3) des Gehäuses (1) vornehmbar ist.

11. Gehäuse nach den Ansprüchen 9 und 10, **dadurch gekennzeichnet, dass** die beiden gleichartig ausgebildeten Profile (2, 3), insbesondere der Schenkel (6) des einen Profils (2), der den Boden (5) bildet, und der Schenkel (8) des zweiten Profils (3), der die Decke (7) bildet, auf ihrer nach außen zugerichteten Seite zumindest teilweise eine gerippte Kühlfläche (17) besitzen.

12. Gehäuse nach Anspruch 11, **dadurch gekennzeichnet, dass** nach dem Fügen der beiden gleichartig ausgebildeten Profile (2, 3) des Gehäuses (1) sowohl der zwischen den Ausnehmungen (10) und den Anformungen (9) als auch der zwischen den Überlappungsflächen (15) gebildete Spalt (16) durch ein Dichtungsmaterial verschlossen ist.

13. Gehäuse nach Anspruch 12, **dadurch gekennzeichnet, dass** die gleichartig ausgebildeten Profile (2, 3) des Gehäuses (1) beim Aufeinanderstecken ihrer Überlappungsflächen (15) über die Verschraubung elektrisch miteinander verbunden sind und andererseits nach dem Ineinanderschieben der miteinander korrespondierenden Anformungen (9) und Ausnehmungen (10) durch aufgeschraubte Abdeckungen an den nicht eloxierten Stirnseiten der gleichartig ausgebildeten Profile (2, 3) elektrisch miteinander verbunden sind.

14. Gehäuse nach Anspruch 13, **dadurch gekennzeichnet, dass** vorzugsweise beide gleichartig ausgebildeten Profile (2, 3) im Bereich der Decke (7) sowie im Bereich des Bodens (5) auf ihrer nach außen zugerichteten Seite Montagehilfen (18) besitzen, über die das Gehäuse (1) mit weiteren Gehäusen oder mit Komponenten eines Produktes am Einsatzort des Gehäuses (1) mit seinen Leiterkarten (22) und weiteren elektronischen und/oder elektrischen Komponenten (23) verbindbar ist.

15. Gehäuse nach Anspruch 14, **dadurch gekennzeichnet, dass** die Montagehilfen (18) aus einer Nut (1) bestehen, über die das Gehäuse (1) auf einen Steg des weiteren Gehäuses oder der jeweiligen Komponente des Produktes am Einsatzort aufschiebbar ist.

16. Gehäuse nach Anspruch 15, **dadurch gekennzeichnet, dass** die Funktionselemente, wie beispielsweise das Display (26) und die Bedienelemente (28) aber auch weitere Außenanschlüsse (27) zumindest in einer der seitlichen Abdeckungen (25) des aus den beiden gleichartig ausgebildeten Profilen (2, 3) bestehenden Gehäuses (1) positioniert sind.
